# EUROPEAN PATENT SPECIFICATION

(11) **EP 2 261 993 B1**
(45) Date of publication and mention of the grant of the patent: **31.12.2014**
(21) Application number: 10181125.5
(22) Date of filing: 10.12.2001
(51) Int. Cl.: H01L 31/02, H05K 1/02, H04N 5/225, H01L 27/146, H01L 31/0203, H01L 31/0232, H04N 7/14

(54) **Semiconductor device**
Halbleitervorrichtung
Dispositif à semi-conducteur

(30) Priority: 28.02.2001 JP 2001055735; 12.10.2001 JP 2001315672
(43) Date of publication of application: 15.12.2010
(62) Divisional of application: 01310313.0
(73) Proprietor: Fujitsu Semiconductor Limited, Kohoku-ku, Yokohama-shi Kanagawa 222-0033 (JP)
(72) Inventor: Honda, Toshiyuki, Kawasaki-shi Kanagawa 211-8588 (JP); Tsuji, Kazuto, Kawasaki-shi Kanagawa 211-8588 (JP); Onodera, Masanori, Kawasaki-shi Kanagawa 211-8588 (JP); Aoki, Hiroshi, Kawasaki-shi Kanagawa 211-8588 (JP); Kobayashi, Izumi, Kawasaki-shi Kanagawa 211-8588 (JP); Moriya, Susumu, Kawasaki-shi Kanagawa 211-8588 (JP); Kaiya, Hiroshi, Kawasaki-shi Kanagawa 211-8588 (JP)
(74) Representative: Stebbing, Timothy Charles

(56) References cited:
- JP-A- 7 099 214
- PATENT ABSTRACTS OF JAPAN vol. 2000, no. 5, 14 September 2000 (2000-09-14) -& JP 2000, 049319, A, (OLYMPUS OPTICAL CO LTD), 18 February 2000 (2000-02-18)
- PATENT ABSTRACTS OF JAPAN vol. 2000, no. 16, 8 May 2001 (2001-05-08) -& JP 2001, 008068, A, (KEIHIN ART WORK:KK;SHIPLEY FAR EAST LTD), 12 January 2001 (2001-01-12)
- PATENT ABSTRACTS OF JAPAN vol. 1999, no. 12, 29 October 1999 (1999-10-29) -& JP 11, 191865, A, (MATSUSHITA ELECTRIC IND CO LTD), 13 July 1999 (1999-07-13)

## Description

### BACKGROUND OF THE INVENTION

### 1. Field of the Invention

The present invention generally relates to semiconductor devices, and more particularly, to a semiconductor device, which unifies a light receiving element and a lens for photographing as a package, and is suitable for photographing.

### 2. Description of the Related Art

Recently, a cellular phone and a mobile personal computer in which a small sized camera is built have been developed. For instance, it is possible to take a picture of a person using the cellular phone by the small sized camera built in the cellular phone, so as to take a picture in the cellular phone as image data, and to transmit the image data to an opponent of the person. Such a small sized camera generally comprises a C-MOS sensor and a lens. There is a demand for miniaturizing the small sized camera for the cellular phone as well as miniaturizing the cellular phone and the mobile personal computer. A semiconductor device package formed by unifying the light receiving element and the lens has been developed to meet the demand for miniaturizing such the small sized camera.

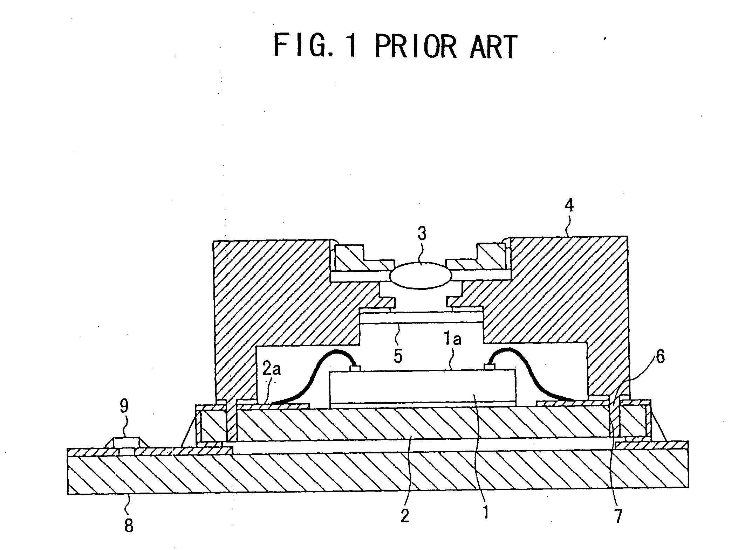

Fig. 1 is a cross-sectional view showing a conventional semiconductor device package unifying a lens for photographing and a semiconductor chip having the C-MOS sensor. In the semiconductor device package shown in Fig. 1, a semiconductor chip 1 having a C-MOS sensor is mounted on a printed circuit board 2 which is rigid and wire-bonded to a pattern wire 2a of the printed circuit board 2, in a state where a light-receiving surface 1a of the chip 1 is top.

A lens 3 for photographing is attached to a housing 4. The housing 4 is fixed on the printed circuit board 2 in a state where the lens 3 is arranged in a designated position above the light-receiving surface 1a of the chip 1. Therefore, the semiconductor device package for the small-sized camera shown in Fig. 1 has a structure where the semiconductor chip is mounted on the board and the lens is arranged above the chip. Further, an IR filter 5 is arranged between the lens 3 and the semiconductor chip 1.

A positioning pin 6 is formed on a base of the housing 4. The housing 4 is precisely positioned on the printed circuit board 2 by inserting the pin 6 in a positioning hole 7 provided in the printed circuit board 2. Thus, it can be carried out to position the lens 3 attached to the housing 4 relative to the semiconductor chip 1 which is mounted on the printed circuit board 2.

In the semiconductor device package having the above-mentioned structure, another printed circuit board 8 is arranged under the printed circuit board 2 in a case where an electronic part 9 such as a capacitor, resistor, and the like is mounted. That is, the printed circuit board 2 having the semiconductor chip 1 and the housing 4 is mounted on the printed circuit board 8, and the electronic part 9 is mounted on the printed circuit board 8.

However, the above-mentioned conventional semiconductor device package has the following disadvantages due to its structure.

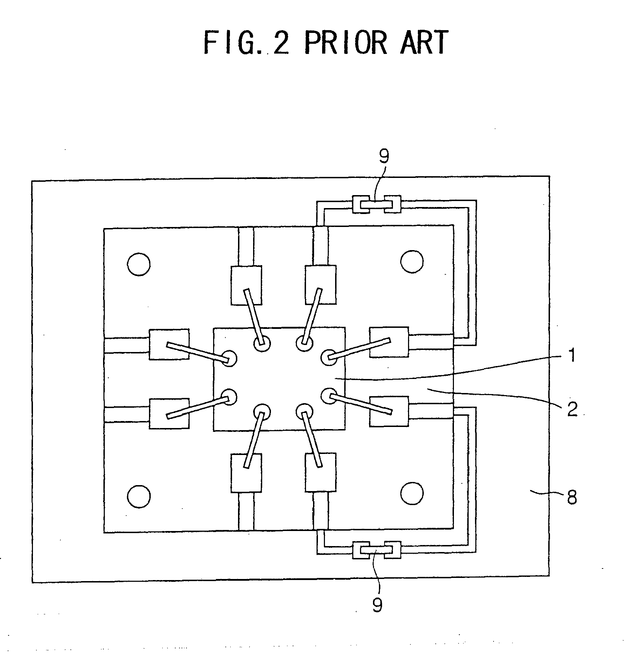

First of all, referring to Fig. 2 which is a plan view showing an arrangement of parts of the semiconductor device package of Fig. 1, the electronic part 9 is arranged outside of the printed circuit board 2 on which the semiconductor chip 1 and the housing 4 are mounted, in a case where the electronic parts 9 are mounted on the printed circuit board 8. Accordingly, the printed circuit board 8 is bigger than the printed circuit board 2, so that the size of the entire semiconductor package is increased.

Secondly, as to a manufacturing process of the semiconductor chip having a light-receiving element, a back of the semiconductor chip 1 is ground by a grinder in order to reduce a thickness of the semiconductor chip 1.

Therefore, the thickness of the semiconductor chip 1 fluctuates on an individual wafer basis. A range of the fluctuation is normally between plus 15 µm and minus 15 µm and an allowable range of the fluctuation is between about plus 30 µ m and minus 30 µm.

In case of that the thickness of the semiconductor chip 1 is fluctuated, a distance between a light-receiving surface 1a of the semiconductor chip 1 and the lens 3 is also fluctuated.

The lens 3 is arranged at a designated distance from the surface of the printed circuit board 2 and the light-receiving surface 1a is arranged at the distance corresponding to the thickness of the semiconductor chip 1 from the surface of the printed circuit board 2. Therefore, the light-receiving surface 1a of the semiconductor chip 1 approaches the lens 3 when the thickness of the semiconductor chip 1 is increased. The light-receiving surface 1a of the semiconductor chip 1 is remote from the lens 3 when the thickness of the semiconductor chip 1 is decreased.

The distance between the lens 3 and the light-receiving surface 1a of the semiconductor chip 1 is set equal to a focal length of the lens 3, so that a picture taken by the lens 3 is formed on the light-receiving surface 1a precisely. Accordingly, if the distance between the light-receiving surface 1a and the lens 3 is fluctuates as described above, there is a problem in that an unfocused state happens and the picture is out of focus.

Thirdly, in case of that the semiconductor chip 1 is mounted on the printed circuit board 2, the semiconductor chip 1 is glued and fixed on a surface of the printed circuit board 2 by a die apparatus.

The die apparatus holds the semiconductor chip 1 by suctioning the surface of the semiconductor chip 1, namely a face on which the light-receiving element is formed, and carries and places the semiconductor chip 1 on the printed circuit board 2. Accordingly, it is impossible to recognize a face on which the light-receiving element is formed by image recognition, because the surface of the semiconductor chip is covered with a suctioning apparatus. Therefore, an external form of the semiconductor chip 1 is recognized by image recognition and the external form is a used as a reference to decide a position of the semiconductor chip on the printed circuit board.

However, a positional relationship between the light-receiving surface 1a of the semiconductor chip 1 and the external form is not always the same. That is, the external form of the semiconductor chip 1 is defined when a wafer is divided by dicing so as to individualize the semiconductor chip 1. The position of the light-receiving surface relative to the external form of the semiconductor chip 1 is changed by changing the cutting position by dicing. Therefore, there may be a case in which a focal position of the lens 3 is not precisely coincident with a center of the light-receiving surface 1a.

Fourthly, a pad for wire-bonding, formed as a part of a wire pattern 2a, must be arranged around the semiconductor chip because the semiconductor chip is mounted on the printed circuit board by wire-bonding. Therefore, it is necessary to provide a place on the printed circuit board 2 where the bonding pad is arranged. The above-mentioned arrangement is an obstacle to miniaturize the semiconductor device package.

Lastly, the substantially necessary thickness as the semiconductor device package is equal to the sum of the focal distance of the lens 3 and the thickness of the semiconductor chip 1. However, according to the above-mentioned conventional semiconductor apparatus package, the actual thickness of the semiconductor device package is equal to the sum of the focal distance of the lens 3, the thickness of the semiconductor chip 1, and the thickness of the printed circuit board 2, because the printed circuit board 2 is arranged at the opposite side of the lens 3 regarding the semiconductor chip 1.

Therefore, the thickness of the semiconductor device package is increased by the thickness of the printed circuit board 2. Besides, when the electronic parts 9 are mounted, the actual thickness of the semiconductor device package is further increased with the thickness of the printed circuit board 8, because the printed circuit board 8 is further equipped under the printed circuit board 2.

JP2000-049319A by Olympus Optical Co., Ltd discloses a semiconductor device for photographing according to the preamble of the accompanying claim.

### SUMMARY OF THE INVENTION

Accordingly, it is a general object of the present invention is to provide a novel and useful semiconductor device in which the problems described above are eliminated.

Another and more specific object of the present invention is to provide a semiconductor device package whose thickness and area are smaller than a conventional device and to provide a method for making the same.

The above objects of the present invention are achieved by a semiconductor device for photographing comprising:
a lens holder including a lens for photographing;
a resin molded body on which the lens holder is provided;
a solid-state image sensing chip mounted on a bottom surface of the resin molded body; and
a board on which the resin molded body is mounted,
wherein the board includes an opening positioned at a place where the resin molded body is mounted, the solid-state image sensing chip is mounted on the bottom surface of the resin molded body in a state where the solid-state image sensing chip is arranged in the opening; characterised in that
the lens holder is separately formed from the resin molded body and separately formed from the lens, and the resin mounted body includes an upper surface on which the lens holder, including the lens, is mounted, and an opening extending between the upper surface on which the lens holder is mounted and the bottom surface on which the solid-state image sensing chip is mounted, and the lens and the solid-state image sensing chip are arranged in a state where light passing through the lens is incident on a light receiving surface of the solid-state image sensing chip through the opening in the resin mounted body.

Other objects, features, and advantages of the present invention will be more apparent from the following detailed description when read in conjunction with the accompanying drawings, in which Figures 1 to 26 show devices and a manufacturing method useful for understanding the present invention, and Fig.s 27 to 34 show an embodiment of the present invention.

### BRIEF DESCRIPTION OF THE DRAWINGS

Fig. 1 is a cross-sectional view showing a conventional semiconductor device package unifying a lens and a semiconductor chip having a C-MOS sensor;
Fig. 2 is a plan view showing an arrangement of parts of the semiconductor device package shown in Fig. 1;
Fig. 3 is a cross-sectional view showing a first semiconductor device package useful for understanding the present invention;
Fig. 4 is a plan view showing an arrangement of parts of the semiconductor device package shown in Fig. 3;
Fig. 5 is a cross-sectional view showing a second semiconductor device package useful for understanding the present invention;
Fig. 6 is a plan view showing an arrangement of the parts of the semiconductor device of Fig. 5;
Fig.s 7 to 18 are views for explaining a manufacturing process of the semiconductor device of Fig. 5;
Fig. 19 is a cross-sectional view showing a third semiconductor device for photographing, useful for understanding the present invention;
Fig. 20 is an enlarged view of a part A shown in Fig. 19;
Fig. 21 is a view for explaining a manufacturing process of the semiconductor device of Fig. 19;
Fig. 22 is a view for explaining the manufacturing process of the semiconductor device of Fig. 19;
Fig. 23 is a cross-sectional view showing a fourth semiconductor device useful for understanding the present invention;
Fig. 24 is an enlarged view of a part A shown in Fig. 23;
Fig. 25 is a plan view showing an arrangement of parts arranged on the part A shown in Fig. 23;
Fig. 26 is a view in a state where a wire pattern is arranged at an under side of electronic parts without forming a projection part;
Fig. 27-(a) is a plan view showing a semiconductor device for photographing according to an embodiment of the present invention and Fig. 27-(b) is a cross-sectional view showing a semiconductor device for photographing according to the embodiment;
Fig. 28 is a plan view showing an example regarding a board shown in Fig. 27;
Fig. 29 is a plan view showing another example regarding a board shown in Fig. 27;
Fig. 30-(a) is a plan view showing a state in which a reinforcement board is attached to a back surface of a board shown in Fig. 28 and Fig. 30-(b) is a side view showing a state in which a reinforcement board is attached to a back surface of a board shown in Fig. 28;
Fig. 31-(a) is a plan view showing a state in which a reinforcement board is attached to a back surface of a board shown in Fig. 29 and Fig. 31-(b) is a side view showing a state in which a reinforcement board is attached to a back surface of a board shown in Fig. 29;
Fig. 32 is a view for explaining the manufacturing method of the semiconductor device for photographing shown in Fig. 27;
Fig. 33 is a plan view showing a metal board before electronic parts are mounted thereon; and
Fig. 34 is a cross-sectional view showing a metal board in a state where electronic parts are mounted thereon.

### DETAIL DESCRIPTION

A description will now be given, with reference to the drawings, of some semiconductor devices useful for understanding the invention, prior to describing an embodiment of the present invention.

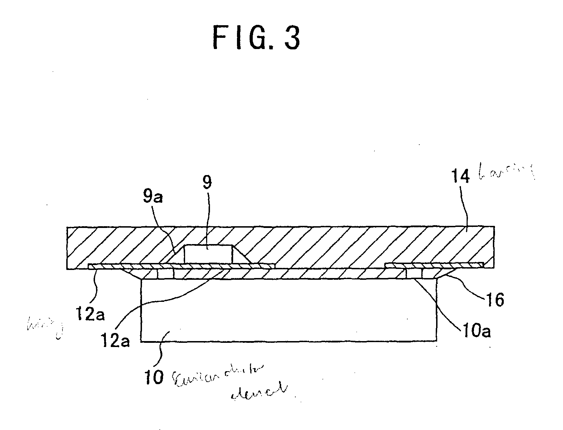

Fig. 3 is a cross-sectional view showing a first semiconductor device package useful for understanding the present invention. The semiconductor device package shown in Fig. 3 includes a semiconductor chip 10, a wire pattern 12a and a housing 14. The semiconductor chip 10 and the housing 14 respectively correspond to the semiconductor chip 1 and the housing 4 shown in Fig. 1. The wire pattern 12a corresponds to the wire pattern 2a formed on the printed circuit board 2 shown in Fig. 1.

That is, the semiconductor device package of Fig. 3 does not have the printed circuit board 2 shown in Fig. 1, and the wire pattern 12a is exposed from a surface of the housing 14 in a state where the wire pattern 12a is molded in the housing 14. A projection electrode 10a of the semiconductor chip 10 is flip chip mounted to the wire pattern 12a by an anisotropic conductive resin 16. Although the wire pattern is formed on the board, the board is removed during the process for manufacturing the semiconductor device package and eventually is in a state shown in Fig. 3. The process for removing the board will be explained later.

On the back side of the wire pattern 12a, namely on the side of the housing 14, an electronic part 9 is connected by a solder 9a. That is, after the electronic part 9 is mounted on the wire pattern 12a, the electronic part 9 and the wire pattern 12a are molded by a resin forming the housing 14.

The housing 14 may be used for the purpose of not only mounting a lens for photographing as described later but also forming a semiconductor device package carrying out various functions with the semiconductor chip 10.

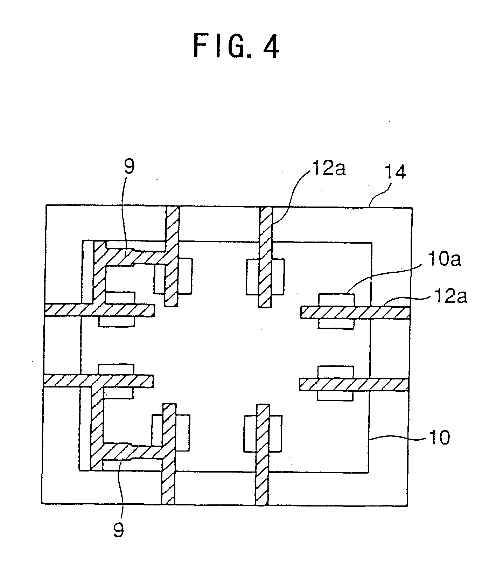

The electronic part 9 related to the semiconductor chip 10 is molded in the housing 14 and arranged inside the area of the semiconductor chip 10 as shown in Fig. 4. Thus, the electronic part 9 is not arranged outside the housing 14, so that the external form of the semiconductor device package does not become large. Furthermore, the printed circuit board 8 for providing the electronic part 9 as shown in Fig. 1 is not necessary, so that the thickness of the semiconductor device package can be decreased by the thickness corresponding to the printed circuit board 8. Besides, since the wire pattern 12a for mounting the semiconductor chip is held in a state where the wire pattern 12a is molded in the housing 14, the printed circuit board 2 shown in Fig. 1 is not needed. Accordingly, the thickness of the semiconductor device package can be further decreased by the thickness corresponding to the printed circuit board 2.

The method of manufacturing the semiconductor device package of Fig. 3 will be further explained as described later.

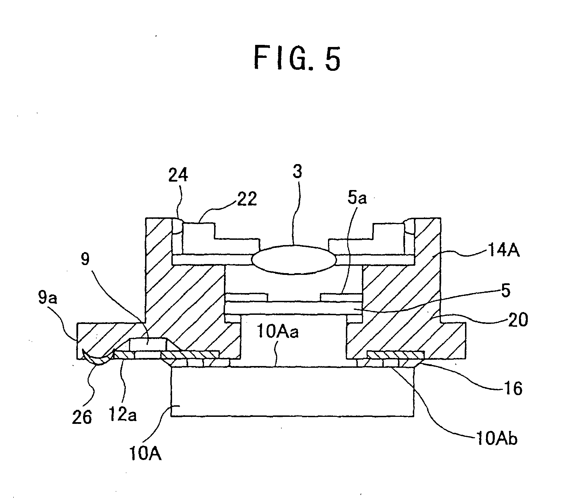

Referring to Fig. 5, a second semiconductor device for photographing, useful for understanding the present invention will be explained as follows. Fig. 5 is a cross-sectional view of this device. In Fig. 5, parts that are the same as the parts shown in Fig. 1 are given the same reference numerals in, and explanation thereof will be omitted.

The semiconductor device shown in Fig. 5 has a structure where a solid-state image sensing chip 10A is used as the semiconductor chip 10, and a housing 14A is used as the housing 14 to which the lens 3 is attached. Accordingly, the electronic part 9 connected to the solid-state image sensing chip 10A is molded in the housing 14A having the lens 3 for photographing. Thus, the semiconductor device is put in a smaller horizontal projective area than the area of the semiconductor device for photographing shown in Fig. 1.

Furthermore, in the semiconductor device of Fig. 5, the printed circuit board for providing the electronic parts 9, namely the printed circuit board 8 shown in Fig. 1, is not necessary. Besides, the wire pattern 12a for mounting the solid-state image sensing chip 10A, namely the semiconductor chip 10, is held by being molded in the housing 14A. Therefore, the printed circuit board for providing the solid-state image sensing chip 10A, namely the printed circuit board 2 shown in Fig. 2, is also not necessary. Thus, a size measured in a height direction, namely the thickness, of the semiconductor device is smaller than that of the semiconductor device for photographing shown in Fig. 1.

As described above, the area and thickness of the semiconductor device shown in Fig. 5 are smaller than them of the semiconductor device for photographing shown in Fig. 1.

Next, a structure of the housing 14A will be explained.

The housing 14A has a through opening in almost center. A light from the lens 3 for photographing is incident through a through opening on a light-receiving surface 10Aa of the solid-state image sensing chip 10A. An IR filter 5 is arranged between the lens 3 for photographing and the light-receiving surface 10Aa of the solid-state image sensing chip 10A. The IR filter 5 is arranged on,a step part of the through opening of the housing 14A and fixed by an adhesive 20. There is an aperture 5a having an opening of a designated size on the lens 3 side of the IR filter 5.

The lens 3 for photographing is provided on the opposite side of the solid-state image sensing chip 10A as to the through opening of the housing 14A and fixed by a lens holding lid 22. The lens holding lid 22 is fixed to the housing 14A by an adhesive 24. Accordingly, a light incident on the lens 3 for photographing is focused by the lens 3 for photographing and is incident on the light-receiving surface 10Aa of the solid-state image sensing chip 10A through the aperture 5a and the IR filter 5.

As described above, the wired pattern 12a is arranged on the base of the housing 14A in a state where the wire pattern 12a is molded in the housing 14A, and a projection electrode (bump) 14Ab of the solid-state image sensing chip 10A is flip chip mounted to the wire pattern 12a. An outside connecting terminal 26 is formed on the base of the housing 14A as an extending part of the wire pattern 12a.

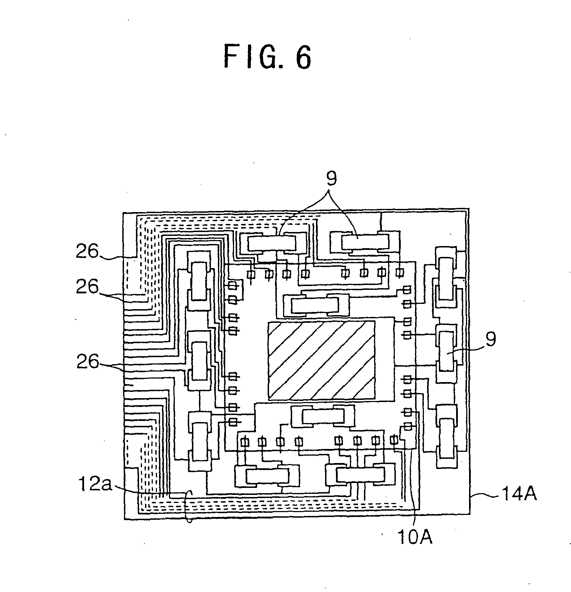

Fig. 6 is a plan view showing an arrangement of the parts of the semiconductor device for photographing as described above. An outermost line shown in Fig. 6 corresponds to the external form of the housing 14A. A hatched center area. corresponds to the light-receiving surface 10Aa of the solid-state image sensing chip 10A.

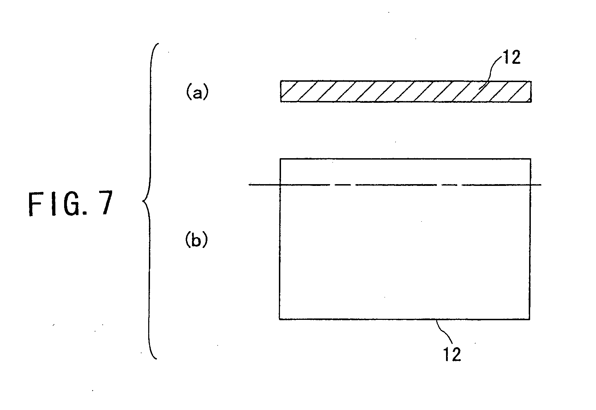

Next, a method for manufacturing the semiconductor device for photographing shown in Fig. 5 will be explained with reference to Figs. 7 to 18. Figs. 7 to 18 are views showing the manufacturing process of the semiconductor device for photographing step by step. In the respective figures of Figs. 7 to 18, (b) is a plan view, and (a) is a cross-sectional view along with a single dashed chain line of the plan view shown in (b).

First of all, as shown in Fig. 7, the board 12 is prepared as a base for forming the wire pattern 12a. The board 12 is a copper plate having a thickness of 0.1 mm.

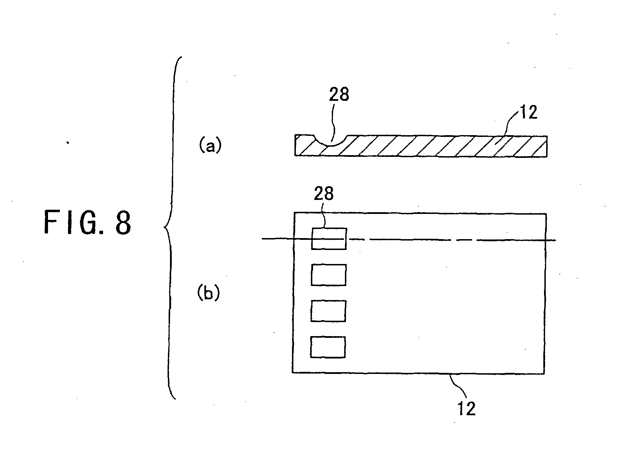

Next, as shown in Fig. 8, a dimple 28 is formed on a designated place of the board 12 by etching, press or the like. The dimple 28 is a hollow part for forming the outside connecting terminal 26 and is formed on the position of the outside connecting terminal 26 shown in Fig. 6.

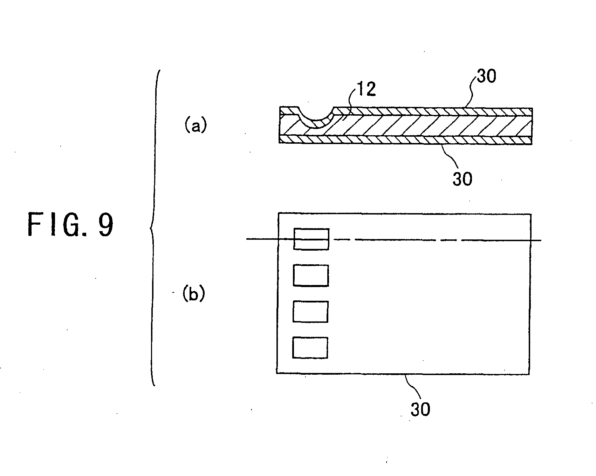

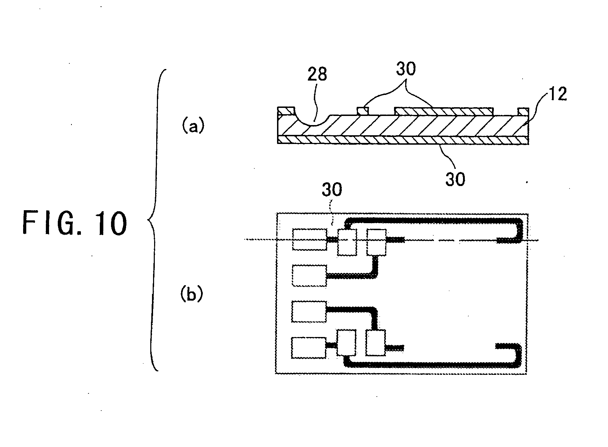

After that, as Fig 9 shows, a photosensitive resist 30 is applied on the entire surface of the backside of the board 12. Then, as shown in Fig. 10, a resist 28 forming the wire pattern 12a is removed. The removal of the resist 28 is preformed by an exposure process or a developing process which is a known technology.

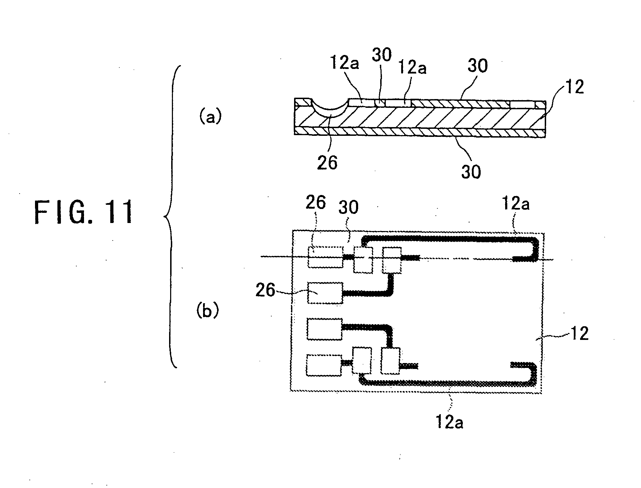

Following the above, as shown in Fig. 11, the wire pattern 12a is formed on the place where the resist 28 is removed. The wire pattern 12a is formed by depositing copper by an electrolytic plating or applying a conductive paste to the place where the resist 28 is removed. In case of using the electrolytic plating, it is preferred that a metal which is different from copper, a material of the board 12, such as gold, nickel or the like is plated first, and then the copper is plated. This is because the etching of the board 12 is stopped so as to remove only the board 12 at the layer of gold or nickel by etching due to difference in the etching speed between copper and gold or nickel.

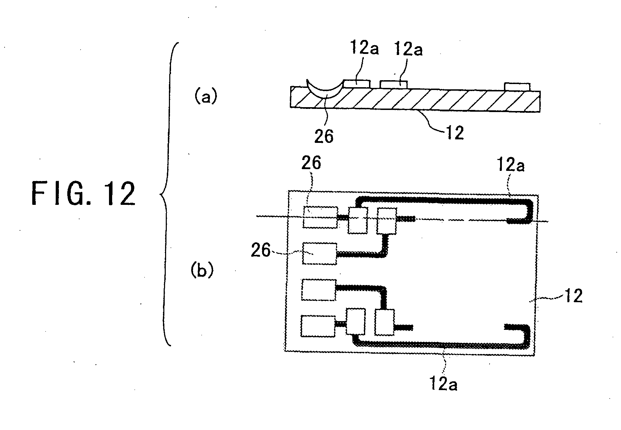

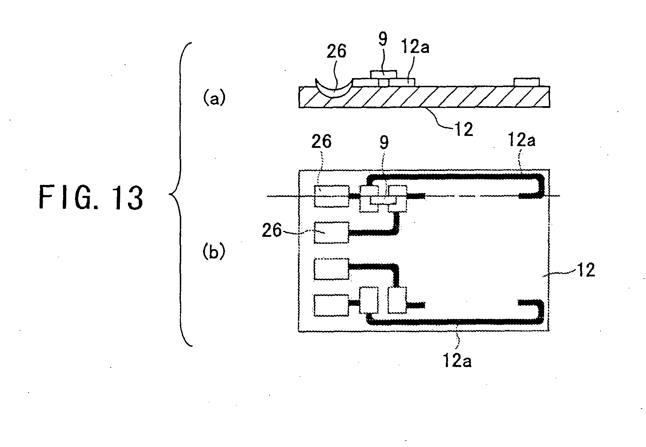

Next, as shown in Fig. 12, the remaining resist 30 is removed. The wire pattern 12a is formed on the board 12 as described above. The plated part in the dimple 28 corresponds to the outside connecting terminal 26. Following the above, as shown in Fig. 13, the electronic part 9 is mounted and soldered with the designated position of the wire pattern on the board 12.

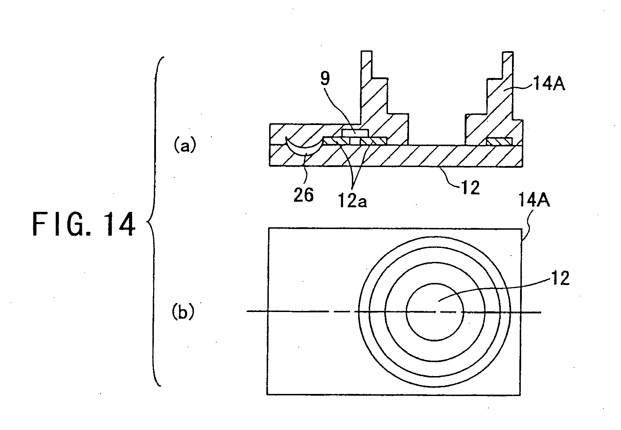

After that, as shown in Fig. 14, the housing 14A is molded by a resin. The housing 14A is formed on the side of that wire pattern 12a is formed. Therefore, the electronic part 9, the wire pattern 12a and the outside connecting terminal 26 are in a state where they are molded in the housing 14A.

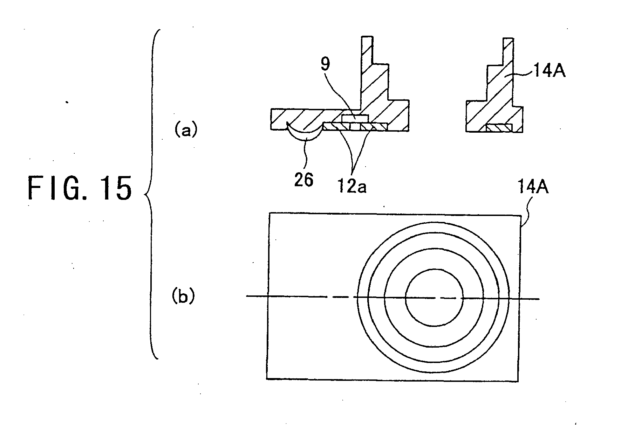

Next, as shown in Fig. 15, the board 12 is removed by etching. Although etching cupper is carried out at this time because the board is formed by copper, it is possible to remove only copper and prevent the wire patter 12a and the outside connecting terminal 26 from being removed if gold or nickel is plated during the plating process shown in Fig. 11. After the board 12 is removed, the housing 14A having the bottom surface on which the wire pattern 12a and the outside connecting terminal 26 are exposed remains. It may be possible to tear the board 12 off instead of removing the board 12 by etching.

The outside connecting terminal 26 projects from the bottom surface of the housing 14A after the board 12 is removed, because the outside connecting terminal 26 is formed in the dimple 28 of the board 12. Thus, in case of that the semiconductor device is connected with another board for instance, it is possible to connect with another board easily by using the projective outside connecting terminal 26. In the meantime, it is not always needed that the outside connecting terminal 26 is projectively arranged. The outside connecting terminal 26 may be only exposed on the bottom surface of the housing 14A as well as the wire pattern 12a. In such a case it is not necessary to form the dimple 28 on the board 12.

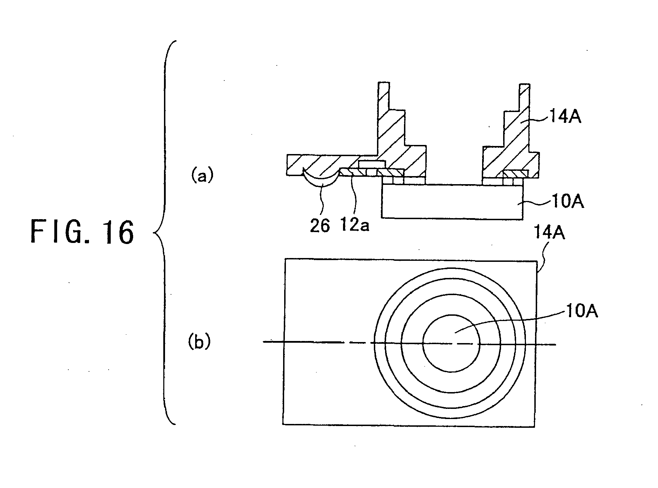

After removing the board 12, as shown in Fig. 16, the solid-state image sensing chip 10A is flip chip mounted to the wire pattern 12a exposed on the bottom surface of the housing 14A by the anisotropic conductive resin 16.

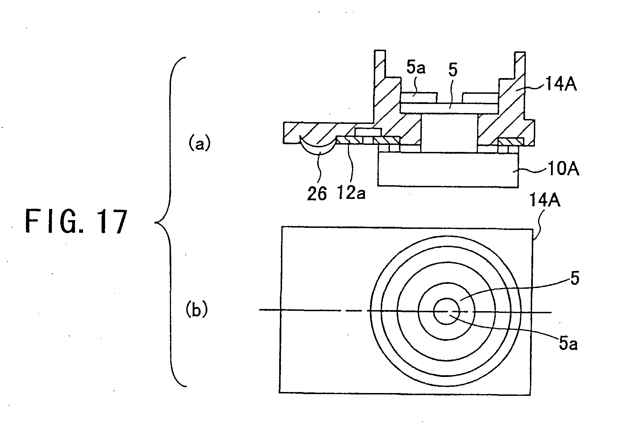

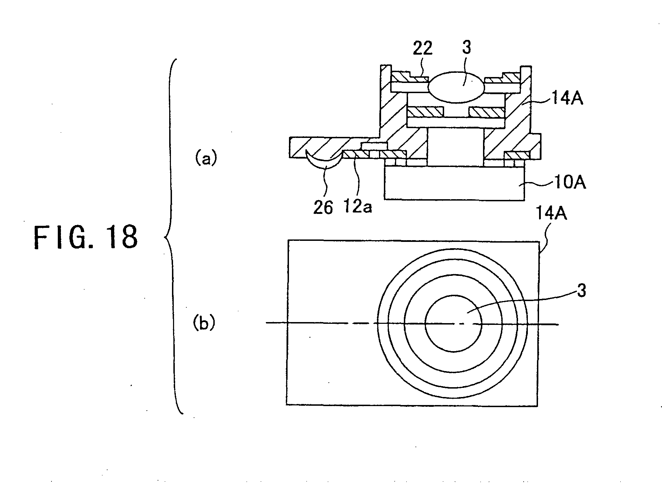

Thereafter, as shown in Fig. 17, the IR filter 5 having the aperture 5a on its upper face is fitted in the housing 14A and fixed by an adhesive. Then, as shown in Fig. 18, the lens 3 is fitted in the housing 14A and fixed by the lens holding lid 22 and the semiconductor device for photographing is completed.

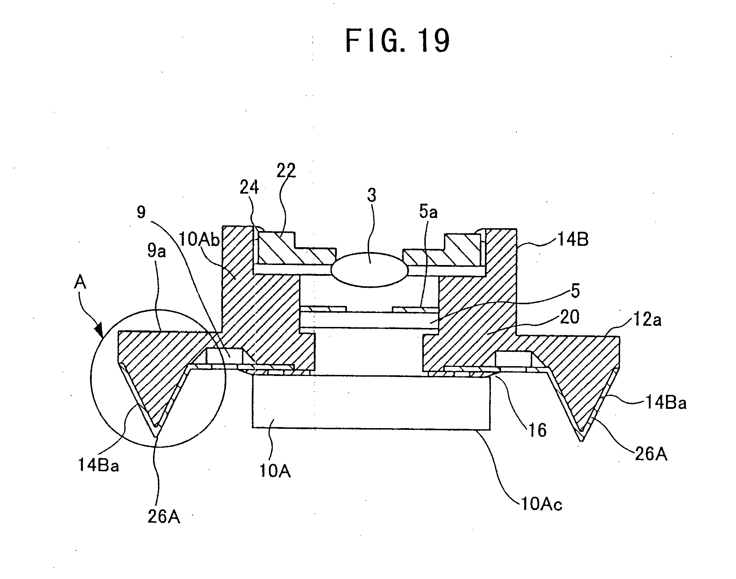

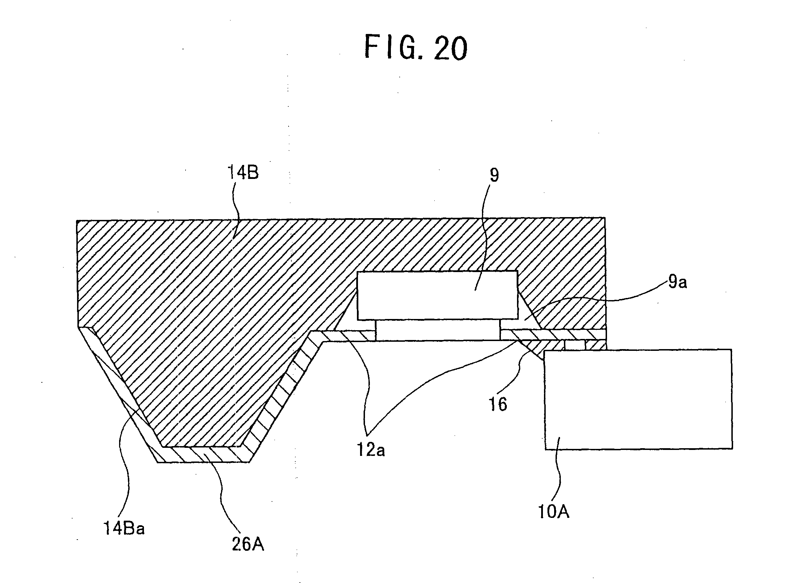

Next, a third semiconductor device useful for understanding the present invention will be explained referring to Figs. 19 and 20. Fig. 19 is a cross-sectional view and Fig. 20 is an enlarged view of a part A shown in Fig. 19. In Figs. 19 and 20, parts that are the same as the parts shown in Fig. 5 are given the same reference numerals in, and explanation thereof will be omitted.

The semiconductor device of Fig.s 19 and 20 substantially has the same structure as the device of Fig. 5 as described above. The difference is a structure of the housing 14A. That is, the semiconductor device of Fig.s 19 and 20 has a housing 14B instead of the housing 14A. Hence, the outside connecting terminal 26 of Fig. 5 is replaced by an outside connecting terminal 26A.

As shown in Figs. 19 and 20, a housing 14B has a projection part 14Ba, which is projected from a back face 10Ac of the solid-state image sensing chip 10A, is near the solid-state image sensing chip 10A. The outside connecting terminal 26A is formed on the projection part 14Ba. Accordingly, the outside connecting terminal 26A is projected from the back face 10Ac of the solid-state image sensing chip 10A.

In the above state, the semiconductor device for photographing is held by the outside connecting terminal 26A, in a case where the semiconductor device for photographing is put on a plane. Accordingly, the semiconductor device can be put on and mounted to the printed circuit board by using the outside connecting terminal 26A, for example. Hence, it is not necessary to prepare a flexible board and the like for connecting external devices, so that cost and size of the apparatus using the semiconductor device for photographing can be reduced.

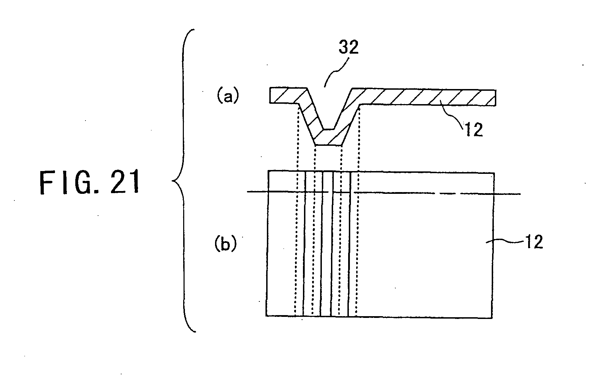

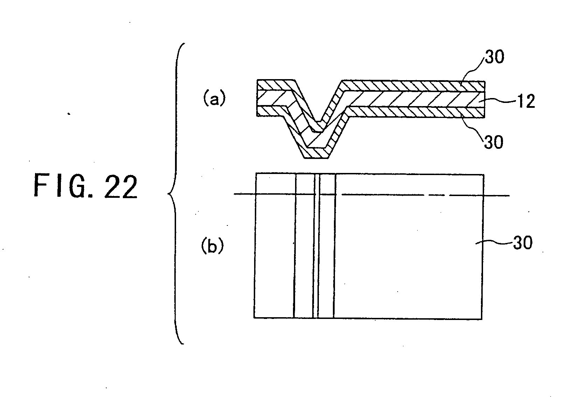

Next, a method of manufacturing the semiconductor device shown in Fig.s 19 and 20 will be explained with reference to Figs. 21 and 22.

The method of manufacturing is substantially the same as the one shown in Figs. 7 to 18 and only the process shown in Fig. 21 is different.

That is, in the process of the method of manufacturing the semiconductor device, a relatively big hollow part 32 is formed by bending the board 12 as shown in Fig. 21, prior to the wire pattern 12a being formed. The process shown in Fig. 21 is carried out instead of the process shown in Fig. 7.

The photosensitive resist 30 is applied on the both faces of the board 12 in order to form the wire pattern 12a. The process shown in Fig. 22 corresponds to the process in Fig. 9. The processes following the process shown in Fig. 22 are the same as the method of manufacturing shown in Fig.s 7 to 18, and their explanations will be omitted.

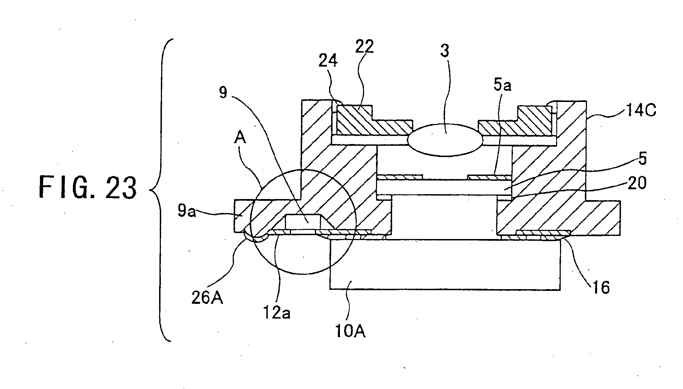

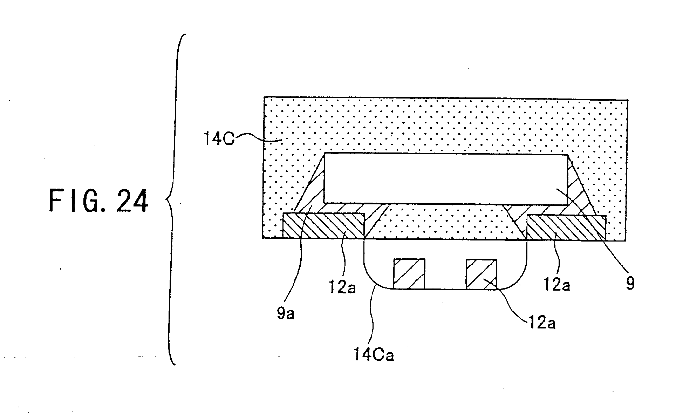

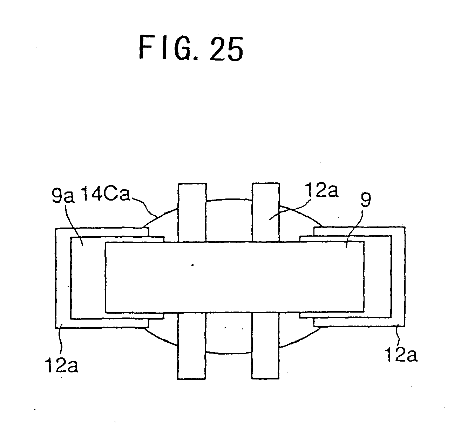

Next, a fourth semiconductor device useful for understanding the present invention will be explained by referring to Figs. 23 and 24. Fig. 23 is a cross-sectional view and Fig. 24 is an enlarged view of a part A shown in Fig. 23. Fig. 25 is a view showing an arrangement of parts arranged on the part A shown in Fig. 23. In Fig. 23 to 25, parts that are the same as the parts shown in Fig. 5 are given the same reference numerals in, and explanation thereof will be omitted.

This semiconductor device has substantially the same structure as the device of Fig. 5, except for the structure of the housing 14A. That is, in Fig.s 23 and 24, a housing 14C replaces the housing 14A of Fig. 5.

As shown in Fig. 23, the housing 14c includes a projection part 14Ca projecting below the electric part 9. As shown in Fig. 24 in detail, a part of the wire pattern 12a is extended to the projection part 14Ca. That is, the wire pattern 12a extended below the electric part 9 is molded in the projection part 14Ca. Hence, it is possible to arrange the wire pattern 12a below the electronic part 9 and to have enough distance between the wire pattern 12a and the solder 9a connecting to the electric parts 9.

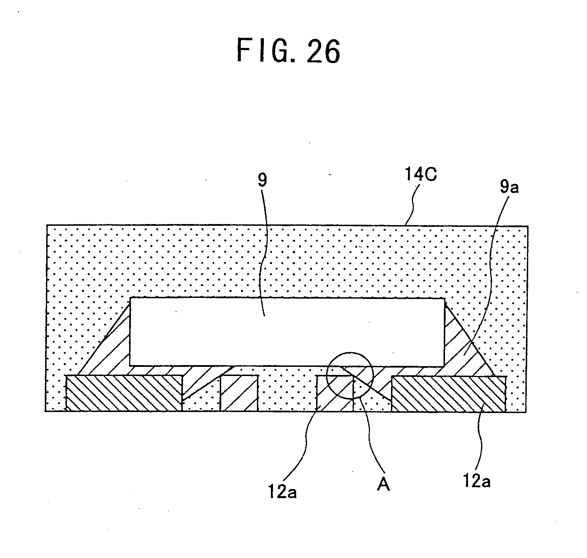

Fig. 26 is a view in a state where a wire pattern 12a is arranged under the electronic part 9 without forming a projection part. In this state, as shown in a part A in the Fig. 26, the distance between the wire pattern 12a and electronic part 9 is very short. Besides, in case of that the solder 9a for connecting with electronic part 9 flows inside of the electronic part 9, there is a possibility that the solder 9a contacts the wire pattern 12a extending below the electronic part 9.

However, if the projection part 14Ca is formed on the housing 14C and the wire pattern 12a is molded in the projection part 14Ca, it is possible to have enough distance between the wire pattern 12a extending below the electric part 9 and the electric part 9 and between the wire pattern 12a extending below the electric part 9 and the solder 9a for connecting the electric part 9. Thus, it is possible to arrange the wire pattern 12a below the electric part 9, and a flexibility to design the wire pattern 12a can be improved.

In the meantime, the projection part 14Ca can be manufactured by a process as well as the process shown in Fig. 11. That is, the dimple is formed in a position where the electric part 9 is arranged on the board 12 and the wire pattern 12a is formed in the dimple, prior to the wire pattern 12a is formed on the board 12.

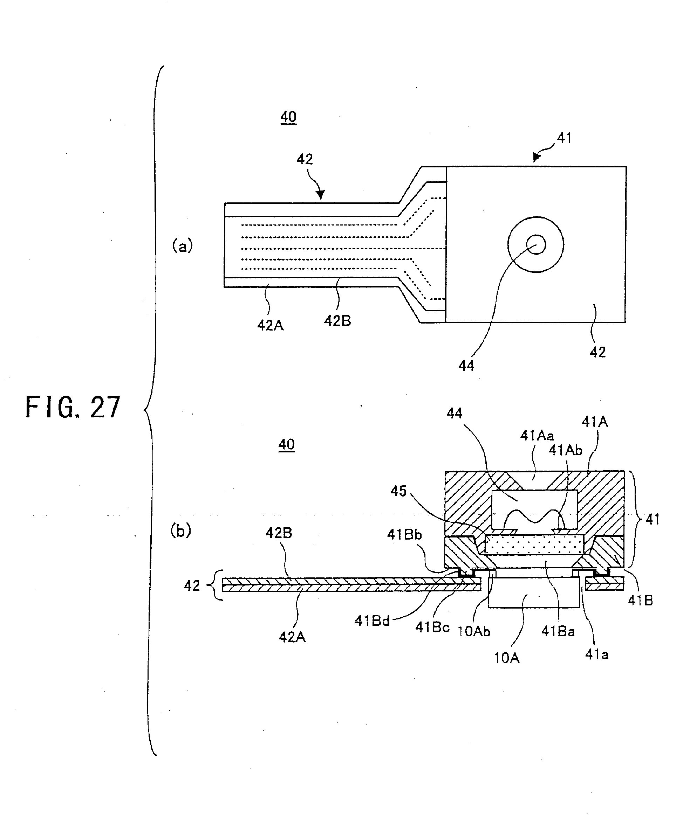

Next, referring to Fig. 27, a semiconductor device 40 for photographing according to an embodiment of the present invention will be explained. Fig. 27-(a) is a plan view showing the semiconductor device for photographing according to the embodiment of the present invention and Fig. 27-(b) is a cross-sectional view showing a semiconductor device for photographing according to the embodiment of the present invention.

The semiconductor device for photographing 40 in the embodiment includes a housing 41 and a board 42. A lens 44 for photographing and the solid-state image sensing chip 10A are provided on the housing 41. The housing 41 is mounted on the board 42.

In the embodiment, the housing 41 is separately formed from a lens holder 41A and a resin molded body 41B made of resin. The lens 44 for photographing is arranged on a substantially center part of the lens holder 41A. An opening part 41Aa is formed on an upper part of the lens 44 for photographing in order to take an image to the lens 44. An aperture 41Ab is formed under the lens 44 for photographing. An IR filter 45 is arranged under the aperture 41Ab.

The lens holder 41A having an above-described structure is provided on the resin molded body 41B having an opening part 41Ba arranged in a center part of the resin molded body 41B. Electronic parts are provided inside of the resin molded body 41B in this embodiment, as in the device of Fig.s 23 and 24. An outside connecting terminal 41Bd is formed on a projection part 41Bc projecting from a bottom surface 41Bb. Providing the electronic parts inside of the resin molded body 41B and forming the outside connecting terminal 41Bd in this embodiment are implemented by an equivalent way to the device of Fig.s 23 and 24, and hence explanation thereof will be omitted.

The solid-state image sensing chip 10A is flip chip mounted to the bottom surface 41Bb of the resin molded body 41B: The light-receiving surface 10Aa of the solid-state image sensing chip 10A faces the lens 44 for photographing through the opening part 41Ba of the resin molded body 41B. Hence, it is possible to form a picture taken by the lens 44 for photographing on the light-receiving surface 10Aa.

In this embodiment, the housing 41 is mounted to the board 42 by the outside connecting terminal 41Bd formed on the bottom surface 41Bb of the resin molded body 41B of the housing 41.

The board 42 includes a polyimide film 42A and a wire 42B. The wire 42B is formed on the polyimide film 42A and made of a copper plate, a copper foil, or the like. An opening part 41a is formed on the board 42 due to existence of the solid-state image sensing chip 10A because the solid-state image sensing chip 10A is connected on the bottom surface 41Bb of the resin molded body 41B.

The solid-state image sensing chip 10A has, for instance, a thickness of 600 µm or less. On the other hand, the board 42 has a thickness of 100 µm or less. The outside connecting terminal 41Bd has a projecting height from the base surface 41Bb of the resin molded body 41B of approximately 80 µm. Therefore, a sum of the thickness of the board 42 and the projecting height of the outside connecting terminal 41Bd is much shorter than the thickness of the solid-state image sensing chip 10A. The total height of the semiconductor device 40 for photographing is a sum of the height of housing 41 and the thickness of the solid-state image sensing chip 10A. In this embodiment, the thickness of the board 42 and the projecting height of the outside connecting terminal 41Bd are not included in the total height of the semiconductor device for photographing 40 because the solid-state image sensing chip 10A is provided in the opening part 41a formed on the board 42. It is a significant advantage of the present invention that the thickness of the board 42 can be reduced from the total height of the semiconductor device 40 for photographing, because the semiconductor device 40 for photographing is generally provided into a small-sized apparatus such as a mobile apparatus.

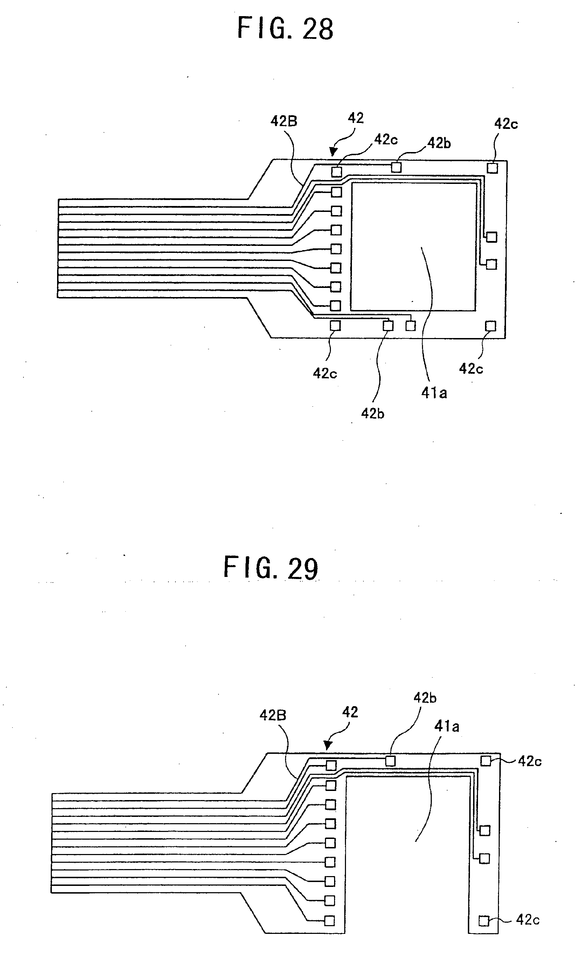

Fig. 28 is a plan view showing an example regarding a board shown in Fig. 27. Electrode lands 42b are provided around the opening part 41a of the board 42. The outside connecting terminal 41Bd of the resin molded body 41B of the housing 41 is connected with the electrode land 42b. The electrode land 42b is lead-connected with an end part of the board 42 by the wire 42B.

Dummy lands (electrode pads) 42c are arranged on vicinities of corners of the opening part 41a of the board 42. The dummy bump 42c is not connected with the wire 42B, thereby the dummy bump 42c electrically isolated. The dummy lands 42c are formed as corresponding to dummy bumps (dummy projection parts) formed on four corners of the resin molded body 41B. The dummy bump of the resin molded body 41B is formed as well as the projection part 41Bc and the outside connecting terminal 41Bd. However, the dummy bump is electrically isolated because the dummy bump is not connected with the electrode of the solid-state image sensing chip 10A which is mounted on the bottom surface 41Bb of the resin molded body 41B. The corners of the board 42 are fixed to the resin molded body 41B by connecting the dummy bumps of the resin molded body 41B with the dummy lands 42c of the board 42.

If the corners of the board 42 are not fixed, disadvantages, such that the corners wind or bend backward during a manufacturing process and in a use for long period of time, may occur. When the outside connecting terminals 41Bd are provided in the vicinity of the four corners of the opening part 41a of the board 42, the outside connecting terminals 41Bd are connected with the electrode lands 42b of the board 42 and corners of the board 42 are fixed. However, depending on the positions of the electrode of the solid-state image sensing chip 10A, it may be unnecessary that the outside connecting terminals 41Bd are provided in the vicinity of the four corners of the opening part 41a. In such case, it is possible to prevent a generation of winding or bending backward of the corners of the opening part 41a of the board 42 by fixing the vicinity of the four corners of the opening part 41a with the resin molded body 41B. If the outside connecting terminals 41Bd are.formed on the four corners of the opening part 42a, the dummy bumps are not necessary to be formed, thereby not the dummy lands 42C but the electrode lands 42b are arranged.

Fig. 29 is a plan view showing another example of the board 42. The opening part 41a of the board 42 shown in Fig. 29 has a opening and rectangular configuration but not having one side. Because of this configuration of the opening part 41a, it may be possible to easily take the solid-state image sensing chip 10A into the opening part 42a. For this structure of the opening part 42a, it is effective to connect the four corners by the dummy bumps.

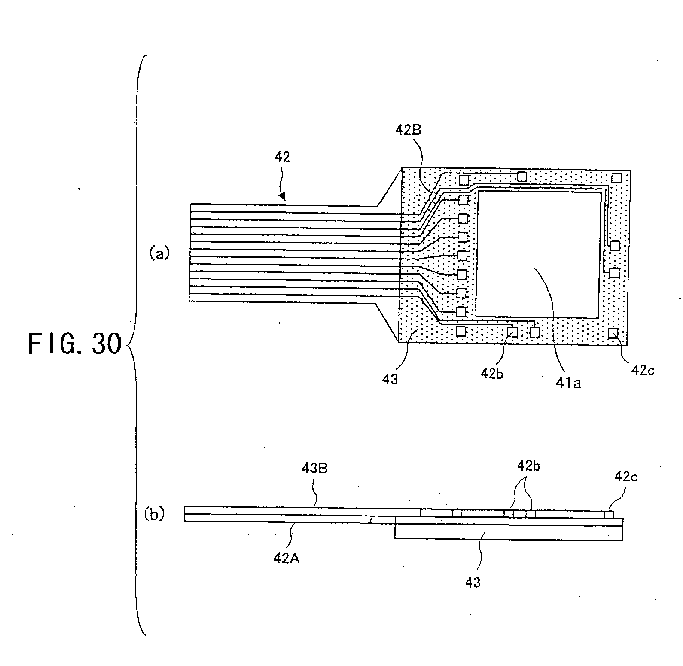

Fig. 30-(a) is a plan view showing a state in which a reinforcement board is stuck on a back surface of the board 42 shown in Fig. 28 and showing the board 42 seen from a side of the wire 42B. Fig. 30-(b) is a side view showing a state in which a reinforcement board is stuck on a back surface of the board shown in Fig. 28. A periphery of the opening part 42a of the board 42 has a narrow width, thereby bending of the board is apt to occur. When bending of the board 42 occur, a gap of the positioning of the resin molded body 41B or an unsatisfactory connection may be generated, at the time when the resin molded body 41B is provided on the board 42. Accordingly, the reinforcement board 43 is attached to the periphery of the opening part 41a of the board 42 by an adhesive or the like, thereby the generation of the bending may be prevented.

The polyimide film may be desirable to be utilized for the reinforcement board 43 as well as the base of the board 42. The reinforcement board 43 has a thickness of 50 µm to 100 µm. If the reinforcement board 43 preferably has a thickness of 50 µm to 100 µm, a sum of the thickness of the board 42 and the thickness of the reinforcement board 43 is shorter than the thickness of the solid-state image sensing chip 10A, thereby the semiconductor device 40 for photographing can have sufficiently small thickness so as to be incorporated into the small-sized apparatus.

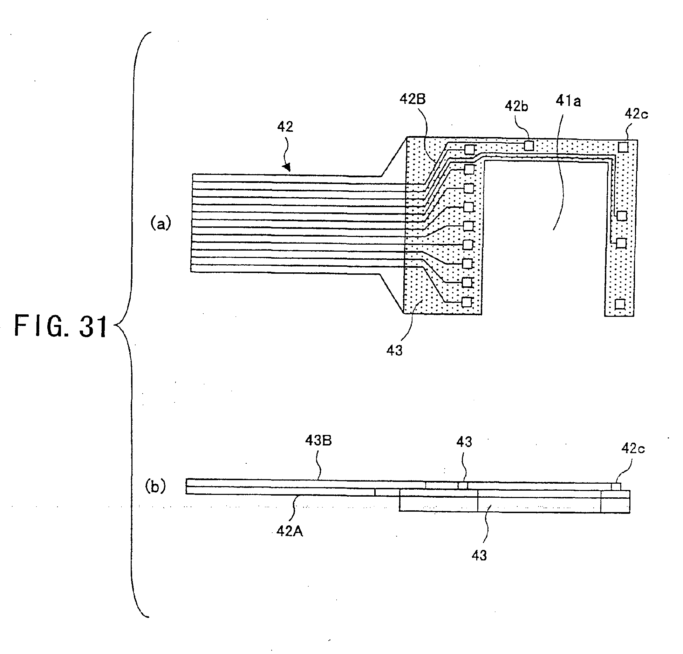

Fig. 31-(a) is a plan view showing a state in which the reinforcement board 46 is attached to the back surface of the board 42 shown in Fig. 29 and showing the board 42 seen from a side of the wire 42B. Fig. 31-(b) is a side view showing a state in which the reinforcement board 46 is attached to the back surface of the board 42 shown in Fig. 29. The advantages of the reinforcement board 46 in Fig. 31 is equivalent to the advantages of the reinforcement board 46 in Fig. 30, therefore the same explanation thereof will be omitted. In this particular case, the opening part 41a has an opening and rectangular configuration but not having one side. Hence, bending of the board 42 is apt to occur. Therefore, it is important to provide the reinforcement board 43 on the board 42.

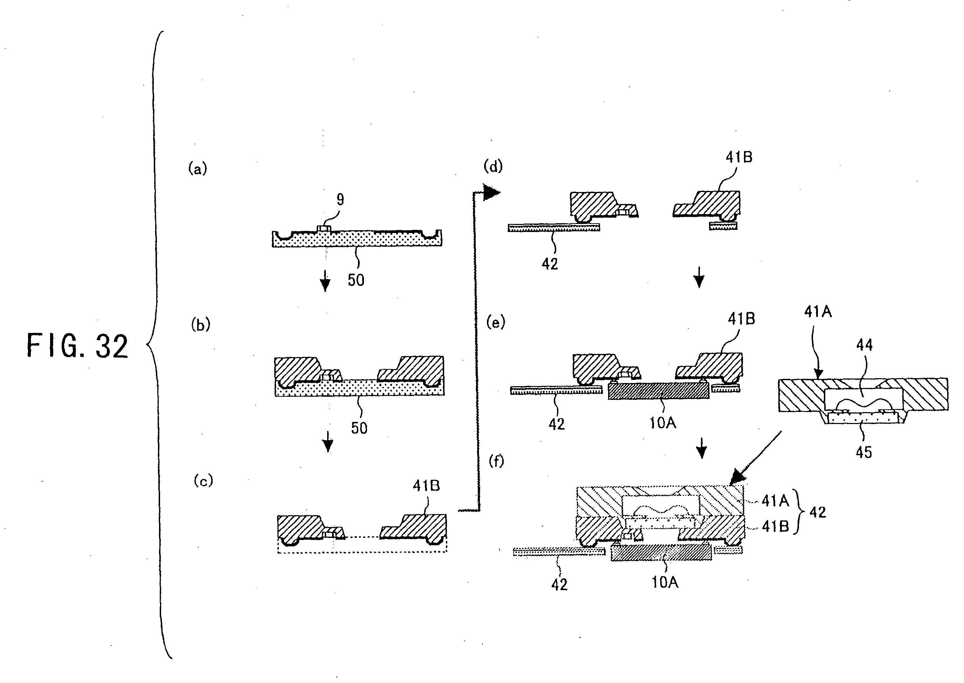

Next, referring to Fig. 32, the manufacturing method of the semiconductor device 40 for photographing will be described.

Although firstly the resin molded body 41B is formed, a detailed explanation thereof will be omitted, because the resin molded body 41B is formed by an equivalent method to the method of manufacturing of the housing 14A in the device of Fig.5.

Processes of manufacturing of the resin molded body 41B are shown in Fig. 32-(a) to (c). As shown in Fig. 32-(a), a wire pattern is formed on a metal board 50 including a concave part in a position thereof which corresponds to the projection part of the resin molded body 41B, and the electronic parts 9 are mounted on the wire pattern. Next, as shown in Fig. 32-(b), the resin molded body 41B is formed by resin-molding. After that, as shown in Fig. 32-(c), the metal board 50 is eliminated.

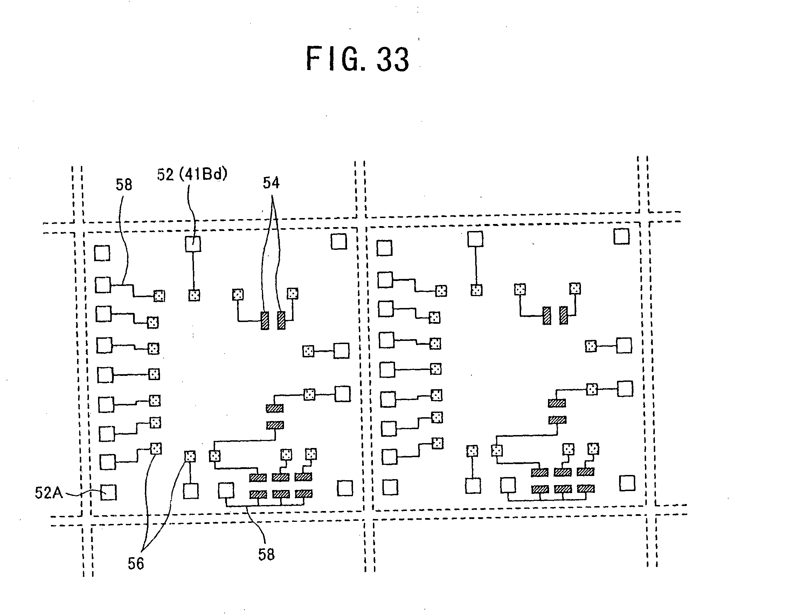

Meanwhile, Fig. 33 is a plan view showing the metal boards 50 in a prior state where the electronic parts 9 are mounted thereon. A plurality of the metal boards 50 are formed on one whole metal board. Firstly, concave parts 52 corresponding to the projection parts 41Bc, and concave parts 52A corresponding to the dummy bumps, are formed on the whole metal board if necessary. And then, the outside connecting terminals 41Bd are formed on the concave parts 52 and the concave parts 52A, and electrode pads 54 for mounting the electronic devices 9 are formed on the whole metal board. Electrode pads 56 for connecting the solid-state image sensing chips 10A are formed on the whole metal board. Wire patterns 58 for connecting the electrode pads 56 with the electrode pads 54, the electrode pads 56 with the outside connecting terminals 41Bd, and the electrode pads 54 with the outside connecting terminals 41Bd, are also formed on the whole metal board. The outside connecting terminals 41Bd, the electrode pads 54, the electrode pads 56, and the wire pattern 58 are formed by the same processes in which the resist is utilized as the processes in Fig.s 7 to 18. After the electrode pads 54 and 56 and the wire pattern 58 are formed on the whole metal board, the whole metal board are cut to make pieces of the metal boards 50. Respective areas of the metal boards 50 are shown as surrounded areas by dotted lines in Fig. 33.

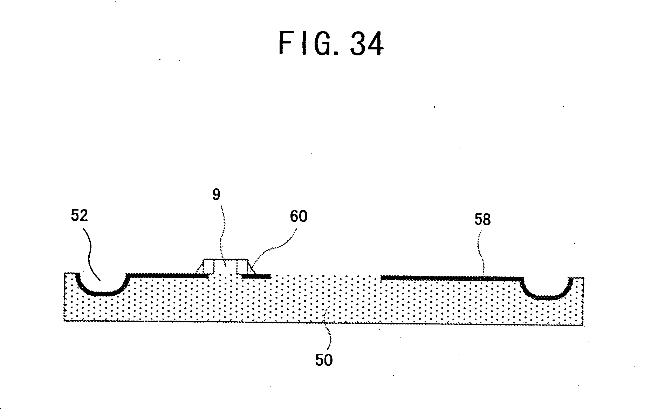

Fig. 34 is a cross-sectional view showing the metal boards 50 in a state where the electronic part 9 is mounted thereon. The electronic part 9 is connected with the electrode pads 54 by conductive pastes. While a solder is utilized as a conductive paste generally, a silver (Ag) paste 60 is utilized in this embodiment.

In this embodiment, the electrode pads 54 and 56 and the wire pattern 58 are, for example, plated with plating layers of palladium (Pd), nickel (Ni), palladium (Pd), gold (Au) from bottom to top. After the electronic part 9 is mounted on the electrode pads 54 by the conductive pastes, the resin molded body 41B is formed by resin-molding. And then, the metal board 50 is eliminated, thereby the electrode pads 54 and 56 and the wire pattern 58 are exposed.

In case of that the electronic part 9 is mounted to the electrode pads 54 by the solder, it may occur on a vicinity of a solder connection part that the electrode pads 54 and the wire pattern 58 are peeled off from the resin molded body 41B. In such case, it may be observed that a discoloration occurs in the vicinity of the solder connection parts of the electrode pad 54 and the wire pattern 58 after the electrode pad 54 and the wire pattern 58 are soldered. This discoloration may occur due to a chemical combination of ingredients of the wire pattern and the solder. Since such peeling frequently occurs at a position where the discoloration occurs, it is assumed that the peeling may be caused by the chemical combination of the ingredients of the wire pattern and the solder.

Because of this, in this embodiment, the electronic part 9 is connected by the silver (Ag) paste 60 which has been utilizing as a die bonding material from the past. It is confirmed that neither the discoloration occurring in case of that the solder is utilized nor the peeling occurs when the silver (Ag) paste is utilized for connecting the electronic part 9. Therefore, for connecting the electronic part 9, firstly a proper quantity of the silver (Ag) paste is applied on the electrode pad 54 formed on the metal board 50. Then, after the electronic part 9 is positioned on a designated position by a mounter, the silver (Ag) paste is heat-melted, thereby the electronic part 9 is completely fixed with the electrode pad 54.

Here, referring back to Fig. 32, the manufacturing method of the semiconductor device 40 for photographing will be continued describing.

The resin molded body 41B formed by the processes shown in Fig. 32-(a) to (c) is mounted to the board 42 as shown in Fig. 32-(d). At this time, the solid-state image sensing chips 10A has not been mounted to the resin molded body 41B yet. Next, as shown in Fig. 32-(e), the solid-state image sensing chips 10A is positioned at the opening part 42a of the board 42 and mounted to the resin molded body 41B by soldering. Lastly, the lens holder 41A in which the lens 44 for photographing and the IR filter 45 are provided is mounted and completely fixed by an adhesive or the like on the resin molded body 41B, thereby the semiconductor device 40 for photographing is completed.

In the above-mentioned manufacturing process, after the resin molded body 41B is mounted to the board 42, the solid-state image sensing chips 10A is mounted to the resin molded body 41B. Assuming that the solid-state image sensing chips 10A is mounted to the resin molded body 41B before the resin molded body 41B is mounted to the board 42, a mounting process of the resin molded body 41B is implemented in case where the light-receiving surface 10Aa of the solid-state image sensing chip 10A is exposed.

Since the mounting process of the resin molded body 41B includes a reflow process of the solder, there is high possibility that a dust or a foreign body is stuck to the light-receiving surface 10Aa of the solid-state image sensing chip 10A in a reflow hearth. Since a light for photographing is incident on the light-receiving surface 10Aa of the solid-state image sensing chip 10A, an adhesion of the dust or the foreign body on the light-receiving surface 10Aa may give a bad-influence to pictures.

In order to prevent such adhesion of the dust or the foreign body, in this embodiment, after a board mounting process in which the resin molded body 41B is mounted to the board 42, an image sensing chip mounting process in which the solid-state image sensing chip 10A is mounted to the resin molded body 41B is implemented. Because of this, it is possible to reduce a time in which the light-receiving surface 10Aa of the solid-state image sensing chip 10A is exposed to an outside atmosphere, thereby a reduction of a yield rate of a product due to the adhesion of the dust is prevented.

Furthermore, a heat-resistance temperature of the solid-state image sensing chip 10A is generally approximately 230 °C which is close to a temperature of a melting point of an eutectic solder which is approximately 220 to 230 °C. Therefore, when the resin molded body 41B is mounted to the board 42 after the solid-state image sensing chip 10A is mounted to the resin molded body 41B, the eutectic solder cannot be utilized. In this case, rather, a solder having a lower melting point such as approximately 180°C than a melting point of the eutectic solder, such as a lead free solder, must be utilized. A connect ability of the lead free solder is lower than a connect ability of the eutectic solder. Therefore, a reliability of a product in which the lead free solder is utilized may be low. However, according to this embodiment of the present invention, as described above, after the board mounting process in which the resin molded body 41B is mounted to the board 42, the image sensing chip mounting process in which the solid-state image sensing chip 10A is mounted to the resin molded body 41B is implemented. Hence, it is possible to utilize various connection materials including the eutectic solder when the resin molded body 41B is mounted to the board 42.

## Claims

1. A semiconductor device for photographing comprising:
a lens holder (41A) including a lens (44) for photographing;
a resin molded body (41B) on which the lens holder (41A) is provided;
a solid-state image sensing chip (10A) mounted on a bottom surface of the resin molded body (41B); and
a board (42) on which the resin molded body (41B) is mounted,
wherein the board (42) includes an opening (41a) positioned at a place where the resin molded body (41B) is mounted, and the solid-state image sensing chip (10A) is mounted on the bottom surface of the resin molded body in a state where the solid-state image sensing chip is arranged in the opening (41a); **characterised in that**
the lens holder (41A) is separately formed from the resin molded body (41B) and separately formed from the lens (44), and the resin molded body (41B) includes an upper surface on which the lens holder (41A), including the lens, is mounted, and an opening (41Ba) extending between the upper surface on which the lens holder (41A) is mounted and the bottom surface on which the solid-state image sensing chip (10A) is mounted, and the lens (44) and the solid-state image sensing chip (10A) are arranged in a state where light passing through the lens (44) is incident on a light receiving surface (10Aa) of the solid-state image sensing chip (10A) through the opening (41Ba) in the resin molded body (41B).

## Patentansprüche

1. Halbleiterbauelement zum Fotografieren, umfassend:
einen Objektivhalter (41A) mit einem Objektiv (44) zum Fotografieren;
einen Harzformkörper (41B), auf dem der Objektivhalter (41A) vorgesehen ist;
einen Festkörperbildabtastchip (10A), der auf eine untere Oberfläche des Harzformkörpers (41B) aufgebracht ist; und
eine Platte (42), auf die der Harzformkörper (41B) aufgebracht ist,
wobei die Platte (42) eine Öffnung (41a) enthält, die an einer Stelle angeordnet ist, an der der Harzformkörper (41B) aufgebracht ist, und der Festkörperbildabtastchip (10A) in einem Zustand auf die untere Oberfläche des Harzformkörpers aufgebracht ist, in dem der Festkörperbildabtastchip in der Öffnung (41a) angeordnet ist; **dadurch gekennzeichnet, dass**
der Objektivhalter (41A) separat vom Harzformkörper (41B) ausgebildet ist und separat vom Objektiv (44) ausgebildet ist, und der Harzformkörper (41B) eine obere Oberfläche, auf die der Objektivhalter (41A), mit dem Objektiv, aufgebracht ist, und eine Öffnung (41Ba) enthält, die zwischen der oberen Oberfläche, auf die der Objektivhalter (41A) aufgebracht ist, und der unteren Oberfläche, auf die der Festkörperbildabtastchip (10A) aufgebracht ist, verläuft, und das Objektiv (44) und der Festkörperbildabtastchip (10A) in einem Zustand angeordnet sind, in dem Licht, das durch das Objektiv (44) tritt, durch die Öffnung (41Ba) im Harzformkörper (41B) auf eine Lichtaufnahmefläche (10Aa) des Festkörperbildabtastchips (10A) auftrifft.

## Revendications

1. Dispositif à semi-conducteurs pour photographier comprenant :
un porte-lentille (41A) comprenant une lentille (44) pour photographier ;
un corps moulé en résine (41B) sur lequel le porte-lentille (41A) est prévu ;
une puce de détection d'image à semi-conducteurs (10A) montée sur une surface de fond du corps moulé en résine (41B) ; et
une carte (42) sur laquelle le corps moulé en résine (41B) est monté,
dans lequel la carte (42) comprend une ouverture (41a) positionnée à un emplacement auquel le corps moulé en résine (41B) est monté, et la puce de détection d'image à semi-conducteurs (10A) est montée sur la surface de fond du corps moulé en résine dans un état dans lequel la puce de détection d'image à semi-conducteurs est agencée dans l'ouverture (41a) ; **caractérisé en ce que**
le porte-lentille (41A) est formé séparément du corps moulé en résine (41B) et formé séparément de la lentille (44), et le corps moulé en résine (41B) comprend une surface supérieure sur laquelle le porte-lentille (41A), comprenant la lentille, est monté, et une ouverture (41Ba) s'étendant entre la surface supérieure sur laquelle le porte-lentille (41A) est monté et la surface de fond sur laquelle la puce de détection d'image à semi-conducteurs (10A) est montée, et la lentille (44) et la puce de détection d'image à semi-conducteurs (10A) sont agencées dans un état dans lequel la lumière passant à travers la lentille (44) frappe une surface de réception de lumière (10Aa) de la puce de détection d'image à semi-conducteurs (10A) à travers l'ouverture (41Ba) dans le corps moulé en résine (41B).
